# EUROPÄISCHE PATENTSCHRIFT

(11) **EP 1 134 557 B1**
(45) Veröffentlichungstag und Bekanntmachung des Hinweises auf die Patenterteilung: **15.10.2008**
(21) Anmeldenummer: 01890065.4
(22) Anmeldetag: 07.03.2001
(51) Int. Cl.: G01D 11/24, H01L 21/56, G01F 1/684

(54) **Verfahren zum Unterbringen von Sensoren in einen Gehäuse**
Method for accomodating sensors in a housing
Procédé de mise en boîtier de capteurs

(30) Priorität: 14.03.2000 AT 4202000
(43) Veröffentlichungstag der Anmeldung: 19.09.2001
(73) Patentinhaber: AUSTRIA MIKRO SYSTEME INTERNATIONAL AKTIENGESELLSCHAFT, A-8141 Unterpremstätten (AT)
(72) Erfinder: Brandl, Manfred Dipl.Ing., 8112 Gratwein (AT)
(74) Vertreter: Haffner, Thomas M.

(56) Entgegenhaltungen:
- EP-A- 0 813 236
- DE-A- 4 219 575
- DE-A- 19 929 025
- GB-A- 2 316 225
- US-A- 4 697 203
- US-A- 5 622 873
- PATENT ABSTRACTS OF JAPAN vol. 1998, no. 03, 27. Februar 1998 (1998-02-27) -& JP 09 304211 A (OMRON CORP), 28. November 1997 (1997-11-28)

## Beschreibung

Die Erfindung bezieht sich auf ein Verfahren zum Unterbringen von Sensoren in einem Gehäuse, insbesondere von chemischen,

Durchfluß-, oder optischen Sensoren in einem Kunststoffgehäuse, wie z.B. beschrieben in DE-A-42 19 575, US-A-4 697 203 oder JP-A-09 304 211.

Chemische Sensoren, ebenso wie Durchfluß- oder optische Sensoren können bereits in integrierter Form mit üblichen Chipherstellungsverfahren kostengünstig und mit hoher Präzision hergestellt werden. Derartige IC-Sensoren bzw. Chipsensoren mußten aber in der Folge unter hohem Montageaufwand in einem Gehäuse eingebaut werden, wobei das Gehäuse in aller Regel entweder verschraubt oder verklebt wurde und die Anschlüsse an die Sensoren in entsprechender Weise aus dem Gehäuse herausgeführt werden mußten. Dies gilt nicht nur für die elektrischen Anschlüsse, sondern bei chemischen-, Durchflußrate- oder optischen Sensoren naturgemäß auch für Leitungsanschlüsse oder Lichtleiteranschlüsse, für die eine entsprechende zusätzliche Bearbeitung der Gehäuse erforderlich war. Für die Herstellung derartiger Sensoren war somit die Unterbringung in einem Gehäuse ein kostenbestimmender Faktor für die Massenproduktion.

Die Erfindung zielt nun darauf ab, ein Verfahren der eingangs genannten Art zu schaffen, bei welchem der Montageaufwand wesentlich verringert werden kann und gleichzeitig die erforderlichen Anschlüsse in kostengünstiger Weise mit wenigen Verfahrensschritten ausgebildet werden können. Zur Lösung dieser Aufgabe besteht das erfindungsgemäße Verfahren im wesentlichen darin, daß in einem ersten Verfahrensschritt die aktive Sensorfläche eines Halbleiter- bzw. IC-Sensors mit einer einen Hohlraum über der aktiven Sensorfläche ausbildenden Kappe versehen wird und der Sensor mit Kontakten bzw. Bonddrähten verbunden wird, daß anschließend das Gehäuse durch Gießen, insbesondere Spritzgießen, angeformt und daß in einem dritten Verfahrensschritt oder gleichzeitig mit dem zweiten Verfahrensschritt der über der aktiven Sensorfläche ausgebildete Hohlraum geöffnet wird. Prinzipiell ist das Vergießen von Chips mit einer geeigneten Vergußmasse für viele elektronische Bauteile bekannt. Die bekannten Verfahren eignen sich jedoch durchwegs nicht für Sensoren, welche in Kontakt mit der Außenwelt stehen müssen, da nach dem Vergießen der Sensor nicht mehr ohne aufwendige Nachbearbeitung zugänglich wird und im Falle einer nachträglichen Bearbeitung die Gefahr einer Beschädigung des Sensors nicht ausgeschlossen werden kann. Dadurch, daß nun erfindungsgemäß in einem ersten Verfahrensschritt die aktive Sensorfläche eines Halbleiter- bzw. IC-Sensors mit einer einen Hohlraum über der aktiven Sensorfläche ausbildenden Kappe versehen wird, wird die entsprechende aktive Sensorfläche von der nachher aufzubringenden Vergußmasse freigehalten. Die Anbringung von Bonddrähten, wie dies bei der Chipherstellung üblich ist, läßt sich mit konventionellen Einrichtungen in einfacher Weise bewerkstelligen, wobei bei einem nachfolgenden Gießvorgang, insbesondere einem Spritzgießvorgang, unmittelbar ein fertiger Bauteil geschaffen wird, welcher bereits alle elektrischen Kontakte aufweist. Es muß somit lediglich sichergestellt werden, daß die aktive Sensorfläche in geeigneter Weise wiederum mit der Umwelt in Kontakt gebracht werden kann, wofür entweder gleichzeitig mit dem zweiten Verfahrensschritt, mit welchem das Gehäuse angegossen bzw. angeformt wird, oder aber in Anschluß an diesen zweiten Verfahrensschritt der Hohlraum mechanisch geöffnet wird. Die Öffnung des Hohlraumes in einem dritten nachgeschalteten Verfahrensschritt ist hiebei gegenüber der gleichzeitigen Ausbildung der Öffnung nicht zuletzt deshalb bevorzugt weil eine gleichzeitige Öffnung des Hohlraumes erfordert, daß beim Schließen der Gußform bzw. der Spritzgußform unmittelbar die Wand der den Hohlraum ausbildenden Kappe durchstoßen wird. Da zu diesem Zeitpunkt die Spritzgußmasse in aller Regel nicht erhärtet ist, hätte dies zur Folge, daß der zuvor positionierte Sensor innerhalb der Gußmasse verschoben wird, wenn nicht ein entsprechendes Widerlager auf der Gegenseite vorgesehen ist. Wenn Spritzguß mit entsprechend höherem Druck vorgenommen wird, müßte in diesem Falle auch sichergestellt werden, daß die Gußform die Kappe dichtend durchtrennt, um zu verhindern, daß Grußmasse in den Hohlraum eingepreßt werden kann. Mit Vorteil wird daher im Rahmen des erfindungsgemäßen Verfahrens so vorgegangen, daß der Hohlraum nach dem zumindest teilweisen Erhärten der Vergußmasse durch Sägen und/oder Bohren geöffnet wird.

In besonders einfacher Weise kann das Gehäuse aus geeigneten Kunststoffen ausgebildet sein, wofür eine Reihe von Kunststoffen in der Halbleitertechnologie sich entsprechend bewährt hat.

Im Falle der Verwendung eines optischen Sensors kann mit Vorteil der Hohlraum durch Bohren geöffnet werden, worauf in den geöffneten Hohlraum ein Lichtleiter eingeführt wird.

Für eine gleichzeitige Ausbildung der elektrischen Kontakte für das Einsetzen eines derartigen mit einem Gehäuse versehenen Sensors in einen Sockel oder in eine entsprechend vorbereitete Leiterplatte kann mit Vorteil so vorgegangen werden, daß die Bonddrähte mit einem Rahmen mit Kontaktstiften verbunden sind und daß der Rahmen unter Freilassen der Kontaktstifte in die Vergußmasse eingebettet wird.

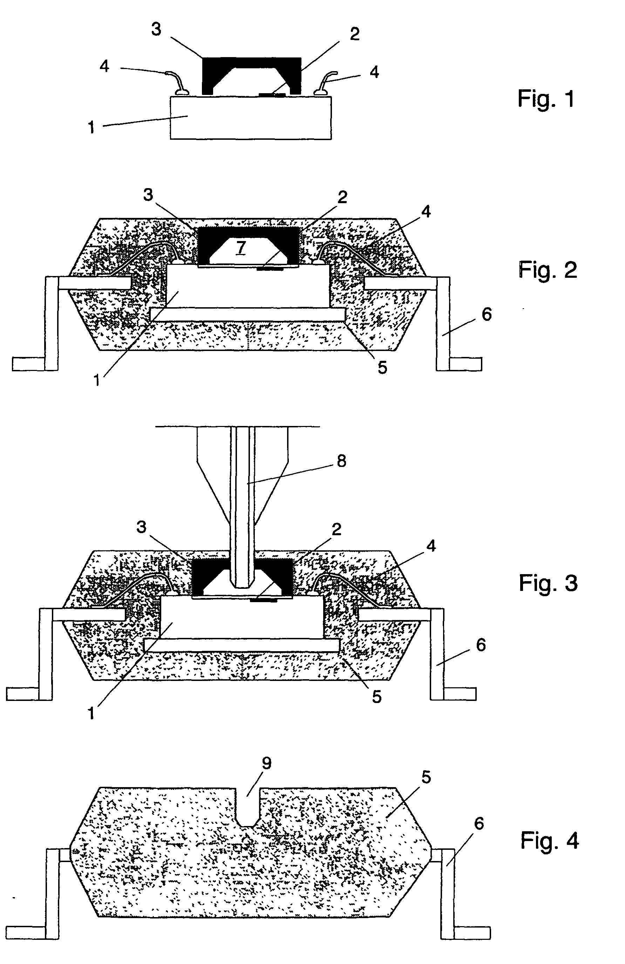

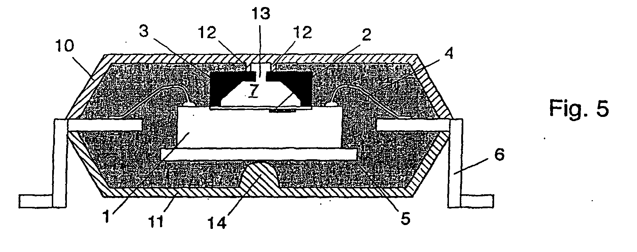

Die Erfindung wird nachfolgend anhand der in der Zeichnung schematisch dargestellten einzelnen Verfahrensschritte näher erläutert. In dieser zeigen Fig. 1 einen Schnitt durch einen Sensor, Fig. 2 einen Schnitt durch den in ein Gehäuse eingebauten Sensor, Fig. 3 einen Schnitt entsprechend Fig. 2 mit einem schematisch dargestellten Bearbeitungswerkzeug zum Öffnen des Hohlraumes, Fig. 4 eine Ansicht des Sensors nach dem Öffnen des Hohlraumes und Fig. 5 einen alternativen Verfahrensschritt zur Ausbildung der Öffnung des Hohlraumes in einer Darstellung entsprechend der Fig. 2.

In Fig. 1 ist 1 ein Sensor-IC bezeichnet, dessen Sensorfläche 2 an der Außenseite des ICs angeordnet ist. Im ersten Verfahrensschritt wird nun eine einen Hohlraum über der aktiven Sensorfläche 2 ausbildende Kappe 3 aufgesetzt und die elektrische Kontaktierung über Bonddrähte 4 vorgenommen.

In Fig. 2 ist das Gehäuse nach dem Spritzvorgang ersichtlich und schematisch mit 5 bezeichnet. Ein Leadframe 6, welcher die entsprechenden Bonddrähte aufweist, ist bereits in das Gehäuse 5 integriert und es ist der verbleibende Hohlraum 7 oberhalb der aktiven Sensorfläche 2 ersichtlich.

Bei der Darstellung nach Fig. 3 ist nun eine Säge mit 8 angedeutet, welche die Außenwand des Gehäuses 5 und die Abdeckkappe 3 entsprechend auftrennt, sodaß eine offene Verbindung zum Hohlraum 7 geschaffen wird, in welchem sich das aktive Sensorelement 2 befindet.

Fig. 4 zeigt den auf diese Weise hergestellten Sensor in einer Ansicht, dessen Öffnung 9 den Zugang der Außenwelt zum aktiven Sensorelement 2 im Inneren des Gehäuses 5 ermöglicht.

In Fig. 5 wird nun der Verfahrensschritt zur Herstellung des Gehäuses unter gleichzeitiger Ausbildung einer Öffnung in einer Darstellung entsprechend der Fig. 2 nochmals verdeutlicht. Bei dieser Verfahrensweise kann auf den in Fig. 3 dargestellten Verfahrensschritt einer nachträglichen Öffnung des Hohlraumes verzichtet werden. Bei dieser Ausbildung ist nun die den Hohlraum ausbildende Kappe 3 bereits mit einer Durchbrechung ausgestattet, wobei die Spritzgußform nunmehr entsprechende Modifikationen aufweisen muß. Die Form besteht hiebei aus einer ersten Formhälfte 10 und einer zweiten Formhälfte 11, wobei die erste Formhälfte 10, welche der Kappe 3 benachbart ist, einwärts ragende Stege 12 aufweist, welche dichtend an die Kappe außerhalb der bereits vorgesehenen Durchbrechung 13 der Kappe angepreßt werden. Zu diesem Zweck weist die zweite Formhälfte 11 ein entsprechendes Druckstück 14 auf, womit die Stege 12 entsprechend dicht an die Kappe 3 angepreßt werden können, sodaß nach dem Entformen unmittelbar ein offener Zugang zum Hohlraum 7 ausgebildet wird.

Insgesamt lassen sich somit mit wenigen für die Serien- und Massenfertigung geeigneten Verfahrensschritten verkapselte und entsprechend in einem Gehäuse eingebaute Sensoren in kostengünstiger Weise herstellen.

## Patentansprüche

1. Verfahren zum Unterbringen von Sensoren in einem Gehäuse (5), insbesondere von chemischen, Durchfluß-, oder optischen Sensoren in einem Kunststoffgehäuse, **dadurch gekennzeichnet, daß** in einem ersten Verfahrensschritt die aktive Sensorfläche (2) eines Halbleiter- bzw. IC-Sensors (1) mit einer einen Hohlraum (7) über der aktiven Sensorfläche (2) ausbildenden Kappe (3) versehen wird und der Sensor (1) mit Kontakten bzw. Bonddrähten (4) verbunden wird, daß in einem zweiten Verfahrensschritt das Gehäuse (5) durch Gießen, insbesondere Spritzgießen, angeformt und daß in einem dritten Verfahrensschritt oder gleichzeitig mit dem zweiten Verfahrensschritt der über der aktiven Sensorfläche (2) ausgebildete Hohlraum (7) geöffnet wird.

2. Verfahren nach Anspruch 1, **dadurch gekennzeichnet, daß** der Hohlraum (7) nach dem zumindest teilweisen Erhärten der Vergußmasse durch Sägen und/oder Bohren geöffnet wird.

3. Verfahren nach Anspruch 1 oder 2, **dadurch gekennzeichnet, daß** das Gehäuse (5) aus Kunststoffen ausgebildet wird.

4. Verfahren nach Anspruch 1, 2 oder 3, **dadurch gekennzeichnet, daß** in den geöffneten Hohlraum (7) ein Lichtleiter eingeführt wird.

5. Verfahren nach einem der Ansprüche 1 bis 4, **dadurch gekennzeichnet, daß** die Bonddrähte (4) mit einem Rahmen (6) mit Kontaktstiften verbunden sind und daß der Rahmen (6) unter Freilassen der Kontaktstifte in die Vergußmasse eingebettet wird.

## Claims

1. A method for housing sensors in a package (5), in particular chemical sensors, flow sensors or optical sensors in a plastics package, **characterised in that** in a first method step the active sensor surface of a semiconductor or IC - sensor (1) is provided with a cap (3) forming a hollow space (7) above the active sensor surface and the sensor (1) is connected with contact means or bond wires (4), that the package (5) is formed by molding, in particular injection molding, and that in a third method step or simultaneously with the second method step the hollow space (7) formed above the active sensor surface (2) is opened.

2. A method according to claim 1, **characterised in that** the hollow space (7) is opened by sawing and/or drilling after the molding compound has at least partially set.

3. A method according to claims 1 or 2, **characterised in that** the package (5) is made of a synthetic material.

4. A method according to claims 1, 2 or 3, **characterised in that** an optical fiber is introduced into the opened hollow space (7).

5. A method according to any one of claims 1 to 4, **characterised in that** the bond wires (4) are connected with a frame (6) including contact pins and that the frame (6) is embedded in the molding compound while leaving the contact pins free.

## Revendications

1. Procédé pour loger des capteurs dans un boîtier (5), en particulier des capteurs chimiques, de débit ou optiques dans un boîtier en matière plastique, **caractérisé en ce que** dans une première étape du procédé, la surface de capteur active (2) d'un capteur à semiconducteurs ou à circuits intégrés (1) est dotée d'un capuchon (3) formant une cavité (7) par-dessus la surface de capteur active (2) et le capteur (1) est muni de contacts ou de fils de liaison (4), **en ce que** dans une deuxième étape du procédé, le boîtier (5) est formé dessus par coulée, en particulier par moulage par injection, **en ce que** dans une troisième étape du procédé ou en même temps que la deuxième étape du procédé, la cavité (7) formée par-dessus la surface de capteur active (2) est ouverte.

2. Procédé selon la revendication 1, **caractérisé en ce que** la cavité (7) est ouverte après le durcissement au moins partiel de la masse d'enrobage par sciage et/ou perçage.

3. Procédé selon la revendication 1 ou 2, **caractérisé en ce que** le boîtier (5) est fait de matières plastiques.

4. Procédé selon la revendication 1, 2 ou 3, **caractérisé en ce qu'**un guide d'ondes lumineuses est introduit dans la cavité (7) ouverte.

5. Procédé selon l'une des revendications 1 à 4, **caractérisé en ce que** les fils de liaison (4) sont reliés à un cadre (6) par des broches de contact et **en ce que** le cadre (6) est inclus dans la masse d'enrobage en laissant dépasser les broches de contact.
